# EUROPEAN PATENT APPLICATION

(11) **EP 3 554 054 A1**
(43) Date of publication of application: **16.10.2019**
(21) Application number: 16923609.8
(22) Date of filing: 07.12.2016
(51) Int. Cl.: H04M 1/02

(54) **MOBILE TERMINAL**

(71) Applicant: LG Electronics Inc., Seoul 07336 (KR)
(72) Inventor: PARK, Kyungui, Seoul 06772 (KR); LEE, Jaewoong, Seoul 06772 (KR); KIM, Sanghoon, Seoul 06772 (KR); LEE, Joseph, Seoul 06772 (KR); PARK, Chansin, Seoul 06772 (KR)
(74) Representative: Vossius & Partner Patentanwälte Rechtsanwälte mbB
(86) International application number: PCT/KR2016/014277
(87) International publication number: WO 2018/105772

(57) **Abstract**

A mobile terminal comprises: a body including an inner space; a main board mounted in the inner space of the body and having a heat generating component mounted thereon; a pipe member comprising a heat pipe including a heat absorbing portion contacting the heat generating component and a heat transfer portion extending from the heat absorbing portion, wherein the heat absorbing portion includes a plate-shaped metal member having an area corresponding to the area of the heat generating component, and the heat transfer portion is made of a material having high thermal conductivity; a first flow path formed inside the pipe member; a second flow path formed on an inner wall of the pipe member; and a working fluid passing through the first flow path in a gaseous state and passing through the second flow path in a liquid state, wherein the heat absorbing portion and the heat transfer portion are integrally formed. As such, the mobile terminal can improve heat dissipation performance, thereby enhancing durability.

## Description

### Technical Field

The present disclosure relates to a mobile terminal with improved heat radiation performance.

### Background Art

Terminals may be generally classified as mobile/portable terminals or stationary terminals according to their mobility. Mobile terminals may also be classified as handheld terminals or vehicle mounted terminals according to whether or not a user can directly carry the terminal.

Mobile terminals have become increasingly more functional. Examples of such functions include data and voice communications, capturing images and video via a camera, recording audio, playing music files via a speaker system, and displaying images and video on a display. Some mobile terminals include additional functionality which supports game playing, while other terminals are configured as multimedia players. More recently, mobile terminals have been configured to receive broadcast and multicast signals which permit viewing of content such as videos and television programs.

As such functions become more diversified, the mobile terminal can support more complicated functions such as capturing images or video, reproducing music or video files, playing games, receiving broadcast signals, and the like. By comprehensively and collectively implementing such functions, the mobile terminal may be embodied in the form of a multimedia player or device.

As the functions of a mobile terminal have been complicated and diversified, much time is taken to use the mobile terminal and a main chip (application processor (AP)) of the mobile terminal processes more and more information. To increase the usability and durability of mobile terminals, there is a need for a heat radiation structure which discharges heat generated from the main chips of the mobile terminals.

### Disclosure

### Technical Problem

An aspect of the present disclosure is to provide a mobile terminal with an improved heat radiation function.

### Technical Solution

A mobile terminal is provided, including a body including an inner space, a main board mounted in the inner space, and configured to mount a heat emission part thereon, and a heat pipe including a heat absorption unit contacting the heat emission part, and a heat transfer unit extended from the heat absorption unit. The heat absorption unit includes a plate-shaped metal member having an area matching an area of the heat emission part. The heat transfer unit includes a pipe member formed of a material with high heat conductivity, a first passage formed inside the pipe member, a second passage formed on an inner sidewall of the pipe member, and a working fluid passing through the first passage in a gas state and passing through the second passage in a liquid state. The heat absorption unit and the heat transfer unit are integrally formed.

The mobile terminal may further include a display unit disposed on a front surface of the body, and a metal frame mounted in the inner space and supporting a rear surface of the display unit. The heat pipe may contact the metal frame.

The metal plate may further include a recess corresponding to a shape of the heat pipe.

The mobile terminal may further include a heat conductive tape interposed between the metal plate and the heat pipe.

The mobile terminal may further include a soldering portion disposed between the heat absorption unit and the heat transfer unit, and configured to engage the heat absorption unit with the heat transfer unit by low-temperature soldering.

The heat absorption unit may include a heat absorption plate including one surface contacting the heat emission part and the other surface engaged with the heat transfer unit by low-temperature soldering, and a heat absorption block disposed around the heat transfer unit on the other surface of the heat absorption plate, and engaged with the heat absorption plate by low-temperature soldering.

The heat absorption unit may include a heat absorption plate including a recess matching the heat transfer unit formed thereon, and one end of the heat transfer unit may be inserted into the recess and engaged with the heat absorption unit.

The heat absorption unit may be formed to be an extension of the pipe member from one end of the heat transfer unit.

The mobile terminal may further include a heat diffusion unit disposed at the other end of the heat transfer unit and including an expanded surface.

The mobile terminal may further include a battery mounted in the inner surface, and the heat transfer unit may be disposed at a side of the battery.

The heat pipe may include a plurality of heat transfer units extended from the heat absorption unit in different directions.

The mobile terminal may include a shield can covering the heat emission part and disposed between the heat emission part and the heat absorption unit, a first heat transfer member interposed between the shield can and the heat emission part, and a second heat transfer member interposed between the shield can and the heat absorption unit.

The shield can may include a sidewall portion fixed on the main board, and a shielding portion mounted on an end portion of the sidewall portion.

The mobile terminal may further include a sidewall portion disposed around the heat emission part, fixed on the main board, and including an end portion engaged with the heat absorption unit, and a third heat transfer member interposed between the heat absorption unit and the heat emission part.

The mobile may include an organic light emitting diode (OLED) display mounted on a front surface of the body.

### Advantageous Effects

The mobile terminal according to the present disclosure may improve heat radiation performance by increasing the area of a heat absorption unit contacting a heat emission part.

Compared to a conventional structure, heat of the heat emission part is efficiently distributed, thereby effectively reducing heat concentrated on the heat emission part and preventing heat-incurred damage to important parts such as a main chip.

Since the heat absorption unit is connected to a heat transfer unit by low-temperature soldering, damage to the passage of a heat pipe may be prevented during the soldering, resulting in a decrease in a failure rate.

Further scope of applicability of the present disclosure will become apparent from the detailed description given hereinafter. However, it should be understood that the detailed description and specific examples, while indicating preferred embodiments of the disclosure, are given by illustration only, since various changes and modifications within the spirit and scope of the disclosure will become apparent to those skilled in the art from this detailed description.

### Brief Description of the Drawings

FIG. 1a is a block diagram of a mobile terminal in accordance with the present disclosure.
FIGS. 1b and 1c are conceptual views of one example of the mobile terminal, viewed from different directions.
FIG. 2 is a view illustrating a rear case of a mobile terminal and parts mounted on the rear case according to the present disclosure.
FIG. 3 is a view illustrating a metal frame and a heat pipe according to the present disclosure.
FIG. 4 is a sectional view illustrating an exemplary metal frame, heat pipe, and main board according to the present disclosure.
FIG. 5 is a sectional view illustrating another exemplary metal frame, heat pipe, and main board according to the present disclosure.
FIG. 6 is a view illustrating various embodiments of a heat pipe according to the present disclosure.
FIG. 7 is a view sequentially illustrating a process of engaging a metal frame with a heat pipe.
FIGS. 8 and 9 are views illustrating other embodiments of a heat pipe according to the present disclosure.
FIG. 10 is a graph illustrating temperatures of a heat emission part in the cases of non-use of a heat pipe, use of a conventional heat pipe, and use of a heat pipe of the present disclosure.
FIG. 11 is a table listing temperature distributions at different points in the cases of non-use of a heat pipe, use of a conventional heat pipe, and use of a heat pipe of the present disclosure.

### Best Mode for Carrying Out the Invention

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

Mobile terminals presented herein may be implemented using a variety of different types of terminals. Examples of such terminals include cellular phones, smart phones, user equipment, laptop computers, digital broadcast terminals, personal digital assistants (PDAs), portable multimedia players (PMPs), navigators, portable computers (PCs), slate PCs, tablet PCs, ultra books, wearable devices (for example, smart watches, smart glasses, head mounted displays (HMDs)), and the like.

By way of non-limiting example only, further description will be made with reference to particular types of mobile terminals. However, such teachings apply equally to other types of terminals, such as those types noted above. In addition, these teachings may also be applied to stationary terminals such as digital TV, desktop computers, and the like.

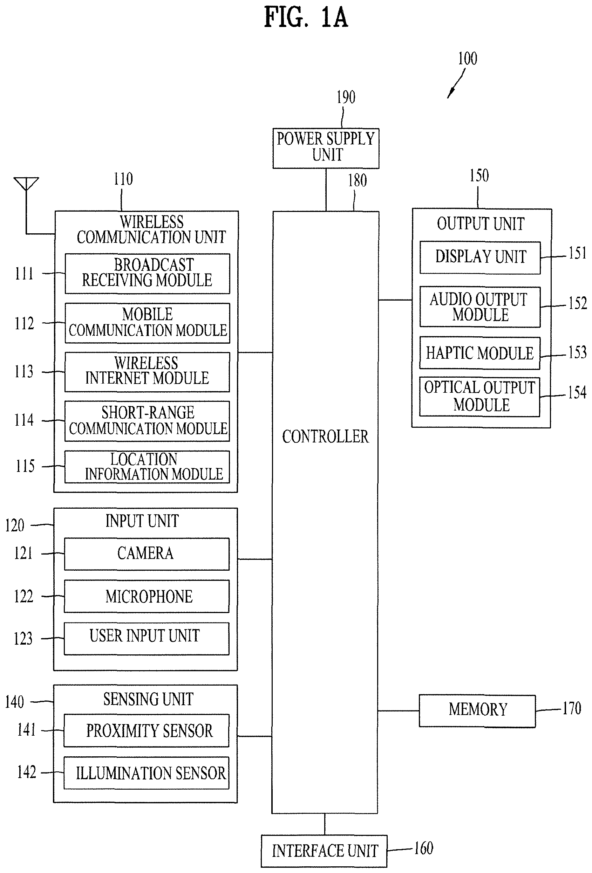

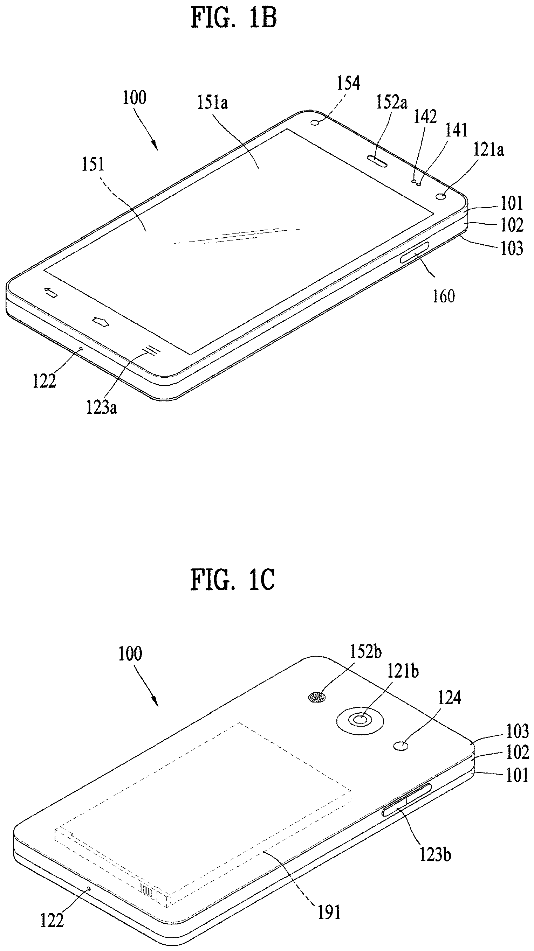

Reference is now made to FIGS. 1A-1C, where FIG. 1A is a block diagram of a mobile terminal in accordance with the present disclosure, and FIGS. 1B and 1C are conceptual views of one example of the mobile terminal, viewed from different directions.

The mobile terminal 100 is shown having components such as a wireless communication unit 110, an input unit 120, a sensing unit 140, an output unit 150, an interface unit 160, a memory 170, a controller 180, and a power supply unit 190. It is understood that implementing all of the illustrated components in The Fig. 1A is not a requirement, and that greater or fewer components may alternatively be implemented.

More specifically, the wireless communication unit 110 typically includes one or more modules which permit communications such as wireless communications between the mobile terminal 100 and a wireless communication system, communications between the mobile terminal 100 and another mobile terminal, communications between the mobile terminal 100 and an external server. Further, the wireless communication unit 110 typically includes one or more modules which connect the mobile terminal 100 to one or more networks.

To facilitate such communications, the wireless communication unit 110 includes one or more of a broadcast receiving module 111, a mobile communication module 112, a wireless Internet module 113, a short-range communication module 114, and a location information module 115.

The input unit 120 includes a camera 121 for obtaining images or video, a microphone 122, which is one type of audio input device for inputting an audio signal, and a user input unit 123 (for example, a touch key, a push key, a mechanical key, a soft key, and the like) for allowing a user to input information. Data (for example, audio, video, image, and the like) is obtained by the input unit 120 and may be analyzed and processed by controller 180 according to device parameters, user commands, and combinations thereof.

The sensing unit 140 is typically implemented using one or more sensors configured to sense internal information of the mobile terminal, the surrounding environment of the mobile terminal, user information, and the like. For example,, the sensing unit 140 may alternatively or additionally include other types of sensors or devices, such as a proximity sensor 141 and an illumination sensor 142, a touch sensor, an acceleration sensor, a magnetic sensor, a G-sensor, a gyroscope sensor, a motion sensor, an RGB sensor, an infrared (IR) sensor, a finger scan sensor, a ultrasonic sensor, an optical sensor (for example, camera 121), a microphone 122, a battery gauge, an environment sensor (for example, a barometer, a hygrometer, a thermometer, a radiation detection sensor, a thermal sensor, and a gas sensor, among others), and a chemical sensor (for example, an electronic nose, a health care sensor, a biometric sensor, and the like), to name a few. The mobile terminal 100 may be configured to utilize information obtained from sensing unit 140, and in particular, information obtained from one or more sensors of the sensing unit 140, and combinations thereof.

The output unit 150 is typically configured to output various types of information, such as audio, video, tactile output, and the like. The output unit 150 is shown having a display unit 151, an audio output module 152, a haptic module 153, and an optical output module 154. The display unit 151 may have an inter-layered structure or an integrated structure with a touch sensor in order to facilitate a touch screen. The touch screen may provide an output interface between the mobile terminal 100 and a user, as well as function as the user input unit 123 which provides an input interface between the mobile terminal 100 and the user.

The interface unit 160 serves as an interface with various types of external devices that can be coupled to the mobile terminal 100. The interface unit 160, for example, may include any of wired or wireless ports, external power supply ports, wired or wireless data ports, memory card ports, ports for connecting a device having an identification module, audio input/output (I/O) ports, video I/O ports, earphone ports, and the like. In some cases, the mobile terminal 100 may perform assorted control functions associated with a connected external device, in response to the external device being connected to the interface unit 160.

The memory 170 is typically implemented to store data to support various functions or features of the mobile terminal 100. For instance, the memory 170 may be configured to store application programs executed in the mobile terminal 100, data or instructions for operations of the mobile terminal 100, and the like. Some of these application programs may be downloaded from an external server via wireless communication. Other application programs may be installed within the mobile terminal 100 at time of manufacturing or shipping, which is typically the case for basic functions of the mobile terminal 100 (for example, receiving a call, placing a call, receiving a message, sending a message, and the like). It is common for application programs to be stored in the memory 170, installed in the mobile terminal 100, and executed by the controller 180 to perform an operation (or function) for the mobile terminal 100.

The controller 180 typically functions to control overall operation of the mobile terminal 100, in addition to the operations associated with the application programs. The controller 180 may provide or process information or functions appropriate for a user by processing signals, data, information and the like, which are input or output, or activating application programs stored in the memory 170.

To drive the application programs stored in the memory 170, the controller 180 may be implemented to control a predetermined number of the components mentioned above in reference with FIG. 1A. Moreover, the controller 180 may be implemented to combinedly operate two or more of the components provided in the mobile terminal 100 to drive the application programs.

The power supply unit 190 can be configured to receive external power or provide internal power in order to supply appropriate power required for operating elements and components included in the mobile terminal 100. The power supply unit 190 may include a battery, and the battery may be configured to be embedded in the terminal body, or configured to be detachable from the terminal body.

Some or more of the components may be operated cooperatively to embody an operation, control or a control method of the mobile terminal in accordance with embodiments of the present disclosure. Also, the operation, control or control method of the mobile terminal may be realized on the mobile terminal by driving of one or more application problems stored in the memory 170.

Hereinafter, referring to FIG. 1, the components mentioned above will be described in detail before describing the various embodiments which are realized by the mobile terminal 100 in accordance with the present disclosure.

Regarding the wireless communication unit 110, the broadcast receiving module 111 is typically configured to receive a broadcast signal and/or broadcast associated information from an external broadcast managing entity via a broadcast channel. The broadcast channel may include a satellite channel, a terrestrial channel, or both. In some embodiments, two or more broadcast receiving modules 111 may be utilized to facilitate simultaneously receiving of two or more broadcast channels, or to support switching among broadcast channels.

The mobile communication module 112 can transmit and/or receive wireless signals to and from one or more network entities. Typical examples of a network entity include a base station, an external mobile terminal, a server, and the like. Such network entities form part of a mobile communication network, which is constructed according to technical standards or communication methods for mobile communications (for example, Global System for Mobile Communication (GSM), Code Division Multi Access (CDMA), CDMA2000(Code Division Multi Access 2000), EV-DO(Enhanced Voice-Data Optimized or Enhanced Voice-Data Only), Wideband CDMA (WCDMA), High Speed Downlink Packet access (HSDPA), HSUPA(High Speed Uplink Packet Access), Long Term Evolution (LTE), LTE-A(Long Term Evolution-Advanced), and the like).

Examples of wireless signals transmitted and/or received via the mobile communication module 112 include audio call signals, video (telephony) call signals, or various formats of data to support communication of text and multimedia messages.

The wireless Internet module 113 is configured to facilitate wireless Internet access. This module may be internally or externally coupled to the mobile terminal 100. The wireless Internet module 113 may transmit and/or receive wireless signals via communication networks according to wireless Internet technologies.

Examples of such wireless Internet access include Wireless LAN (WLAN), Wireless Fidelity (Wi-Fi), Wi-Fi Direct, Digital Living Network Alliance (DLNA), Wireless Broadband (WiBro), Worldwide Interoperability for Microwave Access (WiMAX), High Speed Downlink Packet Access (HSDPA), HSUPA(High Speed Uplink Packet Access), Long Term Evolution (LTE), LTE-A(Long Term Evolution-Advanced), and the like. The wireless Internet module 113 may transmit/receive data according to one or more of such wireless Internet technologies, and other Internet technologies as well.

In some embodiments, when the wireless Internet access is implemented according to, for example, WiBro, HSDPA,HSUPA, GSM, CDMA, WCDMA, LTE, LTE-A and the like, as part of a mobile communication network, the wireless Internet module 113 performs such wireless Internet access. As such, the Internet module 113 may cooperate with, or function as, the mobile communication module 112.

The short-range communication module 114 is configured to facilitate short-range communications. Suitable technologies for implementing such short-range communications include BLUETOOTHTM, Radio Frequency IDentification (RFID), Infrared Data Association (IrDA), Ultra-WideBand (UWB), ZigBee, Near Field Communication (NFC), Wireless-Fidelity (Wi-Fi), Wi-Fi Direct, Wireless USB(Wireless Universal Serial Bus), and the like. The short-range communication module 114 in general supports wireless communications between the mobile terminal 100 and a wireless communication system, communications between the mobile terminal 100 and another mobile terminal 100, or communications between the mobile terminal and a network where another mobile terminal 100 (or an external server) is located, via wireless area networks. One example of the wireless area networks is a wireless personal area networks.

In some embodiments, another mobile terminal (which may be configured similarly to mobile terminal 100) may be a wearable device, for example, a smart watch, a smart glass or a head mounted display (HMD), which is able to exchange data with the mobile terminal 100 (or otherwise cooperate with the mobile terminal 100). The short-range communication module 114 may sense or recognize the wearable device, and permit communication between the wearable device and the mobile terminal 100. In addition, when the sensed wearable device is a device which is authenticated to communicate with the mobile terminal 100, the controller 180, for example, may cause transmission of data processed in the mobile terminal 100 to the wearable device via the short-range communication module 114. Hence, a user of the wearable device may use the data processed in the mobile terminal 100 on the wearable device. For example, when a call is received in the mobile terminal 100, the user may answer the call using the wearable device. Also, when a message is received in the mobile terminal 100, the user can check the received message using the wearable device.

The location information module 115 is generally configured to detect, calculate, derive or otherwise identify a position of the mobile terminal. As an example, the location information module 115 includes a Global Position System (GPS) module, a Wi-Fi module, or both. If desired, the location information module 115 may alternatively or additionally function with any of the other modules of the wireless communication unit 110 to obtain data related to the position of the mobile terminal. As one example, when the mobile terminal uses a GPS module, a position of the mobile terminal may be acquired using a signal sent from a GPS satellite. As another example, when the mobile terminal uses the Wi-Fi module, a position of the mobile terminal can be acquired based on information related to a wireless access point (AP) which transmits or receives a wireless signal to or from the Wi-Fi module.

The input unit 120 may be configured to permit various types of input to the mobile terminal 120. Examples of such input include audio, image, video, data, and user input. Image and video input is often obtained using one or more cameras 121. Such cameras 121 may process image frames of still pictures or video obtained by image sensors in a video or image capture mode. The processed image frames can be displayed on the display unit 151 or stored in memory 170. In some cases, the cameras 121 may be arranged in a matrix configuration to permit a plurality of images having various angles or focal points to be input to the mobile terminal 100. As another example, the cameras 121 may be located in a stereoscopic arrangement to acquire left and right images for implementing a stereoscopic image.

The microphone 122 is generally implemented to permit audio input to the mobile terminal 100. The audio input can be processed in various manners according to a function being executed in the mobile terminal 100. If desired, the microphone 122 may include assorted noise removing algorithms to remove unwanted noise generated in the course of receiving the external audio.

The user input unit 123 is a component that permits input by a user. Such user input may enable the controller 180 to control operation of the mobile terminal 100. The user input unit 123 may include one or more of a mechanical input element (for example, a key, a button located on a front and/or rear surface or a side surface of the mobile terminal 100, a dome switch, a jog wheel, a jog switch, and the like), or a touch-sensitive input, among others. As one example, the touch-sensitive input may be a virtual key or a soft key, which is displayed on a touch screen through software processing, or a touch key which is located on the mobile terminal at a location that is other than the touch screen. On the other hand, the virtual key or the visual key may be displayed on the touch screen in various shapes, for example, graphic, text, icon, video, or a combination thereof.

The sensing unit 140 is generally configured to sense one or more of internal information of the mobile terminal, surrounding environment information of the mobile terminal, user information, or the like. The controller 180 generally cooperates with the sensing unit 140 to control operation of the mobile terminal 100 or execute data processing, a function or an operation associated with an application program installed in the mobile terminal based on the sensing provided by the sensing unit 140. The sensing unit 140 may be implemented using any of a variety of sensors, some of which will now be described in more detail.

The proximity sensor 141 may include a sensor to sense presence or absence of an object approaching a surface, or an object located near a surface, by using an electromagnetic field, infrared rays, or the like without a mechanical contact. The proximity sensor 141 may be arranged at an inner region of the mobile terminal covered by the touch screen, or near the touch screen.

The proximity sensor 141, for example, may include any of a transmissive type photoelectric sensor, a direct reflective type photoelectric sensor, a mirror reflective type photoelectric sensor, a high-frequency oscillation proximity sensor, a capacitance type proximity sensor, a magnetic type proximity sensor, an infrared rays proximity sensor, and the like. When the touch screen is implemented as a capacitance type, the proximity sensor 141 can sense proximity of a pointer relative to the touch screen by changes of an electromagnetic field, which is responsive to an approach of an object with conductivity. In this case, the touch screen (touch sensor) may also be categorized as a proximity sensor.

The term "proximity touch" will often be referred to herein to denote the scenario in which a pointer is positioned to be proximate to the touch screen without contacting the touch screen. The term "contact touch" will often be referred to herein to denote the scenario in which a pointer makes physical contact with the touch screen. For the position corresponding to the proximity touch of the pointer relative to the touch screen, such position will correspond to a position where the pointer is perpendicular to the touch screen. The proximity sensor 141 may sense proximity touch, and proximity touch patterns (for example, distance, direction, speed, time, position, moving status, and the like).In general, controller 180 processes data corresponding to proximity touches and proximity touch patterns sensed by the proximity sensor 141, and cause output of visual information on the touch screen. In addition, the controller 180 can control the mobile terminal 100 to execute different operations or process different data according to whether a touch with respect to a point on the touch screen is either a proximity touch or a contact touch.

A touch sensor can sense a touch applied to the touch screen, such as display unit 151, using any of a variety of touch methods. Examples of such touch methods include a resistive type, a capacitive type, an infrared type, and a magnetic field type, among others.

As one example, the touch sensor may be configured to convert changes of pressure applied to a specific part of the display unit 151, or convert capacitance occurring at a specific part of the display unit 151, into electric input signals. The touch sensor may also be configured to sense not only a touched position and a touched area, but also touch pressure and/or touch capacitance. A touch object is generally used to apply a touch input to the touch sensor. Examples of typical touch objects include a finger, a touch pen, a stylus pen, a pointer, or the like.

When a touch input is sensed by a touch sensor, corresponding signals may be transmitted to a touch controller. The touch controller may process the received signals, and then transmit corresponding data to the controller 180. Accordingly, the controller 180 may sense which region of the display unit 151 has been touched. Here, the touch controller may be a component separate from the controller 180, the controller 180, and combinations thereof.

In some embodiments, the controller 180 may execute the same or different controls according to a type of touch object that touches the touch screen or a touch key provided in addition to the touch screen. Whether to execute the same or different control according to the object which provides a touch input may be decided based on a current operating state of the mobile terminal 100 or a currently executed application program, for example.

The touch sensor and the proximity sensor may be implemented individually, or in combination, to sense various types of touches. Such touches includes a short (or tap) touch, a long touch, a multi-touch, a drag touch, a flick touch, a pinch-in touch, a pinch-out touch, a swipe touch, a hovering touch, and the like.

If desired, an ultrasonic sensor may be implemented to recognize position information relating to a touch object using ultrasonic waves. The controller 180, for example, may calculate a position of a wave generation source based on information sensed by an illumination sensor and a plurality of ultrasonic sensors. Since light is much faster than ultrasonic waves, the time for which the light reaches the optical sensor is much shorter than the time for which the ultrasonic wave reaches the ultrasonic sensor. The position of the wave generation source may be calculated using this fact. For instance, the position of the wave generation source may be calculated using the time difference from the time that the ultrasonic wave reaches the sensor based on the light as a reference signal.

The camera 121 typically includes at least one a camera sensor (CCD, CMOS etc.), a photo sensor (or image sensors), and a laser sensor.

Implementing the camera 121 with a laser sensor may allow detection of a touch of a physical object with respect to a 3D stereoscopic image. The photo sensor may be laminated on, or overlapped with, the display device. The photo sensor may be configured to scan movement of the physical object in proximity to the touch screen. In more detail, the photo sensor may include photo diodes and transistors at rows and columns to scan content received at the photo sensor using an electrical signal which changes according to the quantity of applied light. Namely, the photo sensor may calculate the coordinates of the physical object according to variation of light to thus obtain position information of the physical object.

The display unit 151 is generally configured to output information processed in the mobile terminal 100. For example, the display unit 151 may display execution screen information of an application program executing at the mobile terminal 100 or user interface (UI) and graphic user interface (GUI) information in response to the execution screen information.

In some embodiments, the display unit 151 may be implemented as a stereoscopic display unit for displaying stereoscopic images.

A typical stereoscopic display unit may employ a stereoscopic display scheme such as a stereoscopic scheme (a glass scheme), an auto-stereoscopic scheme (glassless scheme), a projection scheme (holographic scheme), or the like.

The audio output module 152 is generally configured to output audio data. Such audio data may be obtained from any of a number of different sources, such that the audio data may be received from the wireless communication unit 110 or may have been stored in the memory 170. The audio data may be output during modes such as a signal reception mode, a call mode, a record mode, a voice recognition mode, a broadcast reception mode, and the like. The audio output module 152 can provide audible output related to a particular function (e.g., a call signal reception sound, a message reception sound, etc.) performed by the mobile terminal 100. The audio output module 152 may also be implemented as a receiver, a speaker, a buzzer, or the like.

A haptic module 153 can be configured to generate various tactile effects that a user feels, perceive, or otherwise experience. A typical example of a tactile effect generated by the haptic module 153 is vibration. The strength, pattern and the like of the vibration generated by the haptic module 153 can be controlled by user selection or setting by the controller. For example, the haptic module 153 may output different vibrations in a combining manner or a sequential manner.

Besides vibration, the haptic module 153 can generate various other tactile effects, including an effect by stimulation such as a pin arrangement vertically moving to contact skin, a spray force or suction force of air through a jet orifice or a suction opening, a touch to the skin, a contact of an electrode, electrostatic force, an effect by reproducing the sense of cold and warmth using an element that can absorb or generate heat, and the like.

The haptic module 153 can also be implemented to allow the user to feel a tactile effect through a muscle sensation such as the user's fingers or arm, as well as transferring the tactile effect through direct contact. Two or more haptic modules 153 may be provided according to the particular configuration of the mobile terminal 100.

An optical output module 154 can output a signal for indicating an event generation using light of a light source. Examples of events generated in the mobile terminal 100 may include message reception, call signal reception, a missed call, an alarm, a schedule notice, an email reception, information reception through an application, and the like.

A signal output by the optical output module 154 may be implemented in such a manner that the mobile terminal emits monochromatic light or light with a plurality of colors. The signal output may be terminated as the mobile terminal senses that a user has checked the generated event, for example.

The interface unit 160 serves as an interface for external devices to be connected with the mobile terminal 100. For example, the interface unit 160 can receive data transmitted from an external device, receive power to transfer to elements and components within the mobile terminal 100, or transmit internal data of the mobile terminal 100 to such external device. The interface unit 160 may include wired or wireless headset ports, external power supply ports, wired or wireless data ports, memory card ports, ports for connecting a device having an identification module, audio input/output (I/O) ports, video I/O ports, earphone ports, or the like.

The identification module may be a chip that stores various information for authenticating authority of using the mobile terminal 100 and may include a user identity module (UIM), a subscriber identity module (SIM), a universal subscriber identity module (USIM), and the like. In addition, the device having the identification module (also referred to herein as an "identifying device") may take the form of a smart card. Accordingly, the identifying device can be connected with the terminal 100 via the interface unit 160.

When the mobile terminal 100 is connected with an external cradle, the interface unit 160 can serve as a passage to allow power from the cradle to be supplied to the mobile terminal 100 or may serve as a passage to allow various command signals input by the user from the cradle to be transferred to the mobile terminal there through. Various command signals or power input from the cradle may operate as signals for recognizing that the mobile terminal is properly mounted on the cradle.

The memory 170 can store programs to support operations of the controller 180 and store input/output data (for example, phonebook, messages, still images, videos, etc.). The memory 170 may store data related to various patterns of vibrations and audio which are output in response to touch inputs on the touch screen.

The memory 170 may include one or more types of storage mediums including a Flash memory, a hard disk, a solid state disk, a silicon disk, a multimedia card micro type, a card-type memory (e.g., SD or DX memory, etc), a Random Access Memory (RAM), a Static Random Access Memory (SRAM), a Read-Only Memory (ROM), an Electrically Erasable Programmable Read-Only Memory (EEPROM), a Programmable Read-Only memory (PROM), a magnetic memory, a magnetic disk, an optical disk, and the like. The mobile terminal 100 may also be operated in relation to a network storage device that performs the storage function of the memory 170 over a network, such as the Internet

The controller 180 may typically control the general operations of the mobile terminal 100. For example, the controller 180 may set or release a lock state for restricting a user from inputting a control command with respect to applications when a status of the mobile terminal meets a preset condition.

The controller 180 can also perform the controlling and processing associated with voice calls, data communications, video calls, and the like, or perform pattern recognition processing to recognize a handwriting input or a picture drawing input performed on the touch screen as characters or images, respectively. In addition, the controller 180 can control one or a combination of those components in order to implement various exemplary embodiments disclosed herein.

The power supply unit 190 may be provided with the power supplied by an external power source and the power supplied therein under the control of the controller 180 so as to supply the needed power to each of the components. The power supply unit 190 may include a battery. The battery may be a built-in type which is rechargeable and detachably loaded in the terminal to be charged.

The power supply unit 190 may include a connection port. The connection port may be configured as one example of the interface unit 160 to which an external charger for supplying power to recharge the battery is electrically connected.

As another example, the power supply unit 190 may be configured to recharge the battery in a wireless manner without use of the connection port. In this example, the power supply unit 190 can receive power, transferred from an external wireless power transmitter, using at least one of an inductive coupling method which is based on magnetic induction or a magnetic resonance coupling method which is based on electromagnetic resonance.

Various embodiments described herein may be implemented in a computer-readable medium, a machine-readable medium, or similar medium using, for example, software, hardware, or any combination thereof.

Referring now to FIGS. 1B and 1C, the mobile terminal 100 is described with reference to a bar-type terminal body. However, the mobile terminal 100 may alternatively be implemented in any of a variety of different configurations. Examples of such configurations include watch-type, clip-type, glasses-type, or as a folder-type, flip-type, slide-type, swing-type, and swivel-type in which two and more bodies are combined with each other in a relatively movable manner, and combinations thereof. Discussion herein will often relate to a particular type of mobile terminal (for example, bar-type, watch-type, glasses-type, and the like). However, such teachings with regard to a particular type of mobile terminal will generally apply to other types of mobile terminals as well.

Here, the terminal body may be understood to refer to the concept of this bore a mobile terminal (100) to at least one of the aggregate.

The mobile terminal 100 will generally include a case (for example, frame, housing, cover, and the like) forming the appearance of the terminal. In this embodiment, the case is formed using a front case 101 and a rear case 102. Various electronic components are incorporated into a space formed between the front case 101 and the rear case 102. At least one middle case may be additionally positioned between the front case 101 and the rear case 102.

The display unit 151 is shown located on the front side of the terminal body to output information. As illustrated, a window 151a of the display unit 151 may be mounted to the front case 101 to form the front surface of the terminal body together with the front case 101.

In some embodiments, electronic components may also be mounted to the rear case 102. Examples of such electronic components include a detachable battery 191, an identification module, a memory card, and the like. Rear cover 103 is shown covering the electronic components, and this cover may be detachably coupled to the rear case 102. Therefore, when the rear cover 103 is detached from the rear case 102, the electronic components mounted to the rear case 102 are externally exposed.

As illustrated, when the rear cover 103 is coupled to the rear case 102, a side surface of the rear case 102 is partially exposed. In some cases, upon the coupling, the rear case 102 may also be completely shielded by the rear cover 103. In some embodiments, the rear cover 103 may include an opening for externally exposing a camera 121b or an audio output module 152b.

The cases 101, 102, 103 may be formed by injection-molding synthetic resin or may be formed of a metal, for example, stainless steel (STS), aluminum (Al), titanium (Ti), or the like.

As an alternative to the example in which the plurality of cases form an inner space for accommodating components, the mobile terminal 100 may be configured such that one case forms the inner space. In this example, a mobile terminal 100 having a unibody is formed in such a manner that synthetic resin or metal extends from a side surface to a rear surface.

If desired, the mobile terminal 100 may include a waterproofing unit (not shown) for preventing introduction of water into the terminal body. For example, the waterproofing unit may include a waterproofing member which is located between the window 151a and the front case 101, between the front case 101 and the rear case 102, or between the rear case 102 and the rear cover 103, to hermetically seal an inner space when those cases are coupled.

The mobile terminal 100 may include the display unit 151, the audio output module, the proximity sensor 141, the illuminance sensor 142, the optical output module 154, the camera 121, the user input unit 123, the microphone 122 and the interface unit 160.

It will be described for the mobile terminal as shown in FIGS. 1B and 1C. The display unit 151, the first audio output module 152a, the proximity sensor 141, an illumination sensor 142, the optical output module 154, the first camera 121a and the first manipulation unit 123a are arranged in front surface of the terminal body, the second manipulation unit 123b, the microphone 122 and interface unit 160 are arranged in side surface of the terminal body, and the second audio output modules 152b and the second camera 121b are arranged in rear surface of the terminal body.

It is to be understood that alternative arrangements are possible and within the teachings of the instant disclosure. Some components may be omitted or rearranged. For example, the first manipulation unit 123a may be located on another surface of the terminal body, and the second audio output module 152b may be located on the side surface of the terminal body.

The display unit 151 is generally configured to output information processed in the mobile terminal 100. For example, the display unit 151 may display execution screen information of an application program executing at the mobile terminal 100 or user interface (UI) and graphic user interface (GUI) information in response to the execution screen information.

The display unit 151 outputs information processed in the mobile terminal 100. The display unit 151 may be implemented using one or more suitable display devices. Examples of such suitable display devices include a liquid crystal display (LCD), a thin film transistor-liquid crystal display (TFT-LCD), an organic light emitting diode (OLED), a flexible display, a 3-dimensional (3D) display, an e-ink display, and combinations thereof.

The display unit 151 may be implemented using two display devices, which can implement the same or different display technology. For instance, a plurality of the display units 151 may be arranged on one side, either spaced apart from each other, or these devices may be integrated, or these devices may be arranged on different surfaces.

The display unit 151 may also include a touch sensor which senses a touch input received at the display unit. When a touch is input to the display unit 151, the touch sensor may be configured to sense this touch and the controller 180, for example, may generate a control command or other signal corresponding to the touch. The content which is input in the touching manner may be a text or numerical value, or a menu item which can be indicated or designated in various modes.

The touch sensor may be configured in a form of a film having a touch pattern, disposed between the window 151a and a display on a rear surface of the window 151a, or a metal wire which is patterned directly on the rear surface of the window 151a. Alternatively, the touch sensor may be integrally formed with the display. For example, the touch sensor may be disposed on a substrate of the display or within the display.

The display unit 151 may also form a touch screen together with the touch sensor. Here, the touch screen may serve as the user input unit 123 (see FIG. 1A). Therefore, the touch screen may replace at least some of the functions of the first manipulation unit 123a.

The first audio output module 152a may be implemented in the form of a speaker to output voice audio, alarm sounds, multimedia audio reproduction, and the like.

The window 151a of the display unit 151 will typically include an aperture to permit audio generated by the first audio output module 152a to pass. One alternative is to allow audio to be released along an assembly gap between the structural bodies (for example, a gap between the window 151a and the front case 101). In this case, a hole independently formed to output audio sounds may not be seen or is otherwise hidden in terms of appearance, thereby further simplifying the appearance and manufacturing of the mobile terminal 100.

The optical output module 154 can be configured to output light for indicating an event generation. Examples of such events include a message reception, a call signal reception, a missed call, an alarm, a schedule notice, an email reception, information reception through an application, and the like. When a user has checked a generated event, the controller can control the optical output unit 154 to stop the light output.

The first camera 121a can process image frames such as still or moving images obtained by the image sensor in a capture mode or a video call mode. The processed image frames can then be displayed on the display unit 151 or stored in the memory 170.

The first and second manipulation units 123a and 123b are examples of the user input unit 123, which may be manipulated by a user to provide input to the mobile terminal 100. The first and second manipulation units 123a and 123b may also be commonly referred to as a manipulating portion, and may employ any tactile method that allows the user to perform manipulation such as touch, push, scroll, or the like. The first and second manipulation units 123a and 123b may also employ any non-tactile method that allows the user to perform manipulation such as proximity touch, hovering, or the like.

FIG. 1B illustrates the first manipulation unit 123a as a touch key, but possible alternatives include a mechanical key, a push key, a touch key, and combinations thereof.

Input received at the first and second manipulation units 123a and 123b may be used in various ways. For example, the first manipulation unit 123a may be used by the user to provide an input to a menu, home key, cancel, search, or the like, and the second manipulation unit 123b may be used by the user to provide an input to control a volume level being output from the first or second audio output modules 152a or 152b, to switch to a touch recognition mode of the display unit 151, or the like.

As another example of the user input unit 123, a rear input unit (not shown) may be located on the rear surface of the terminal body. The rear input unit can be manipulated by a user to provide input to the mobile terminal 100. The input may be used in a variety of different ways. For example, the rear input unit may be used by the user to provide an input for power on/off, start, end, scroll, control volume level being output from the first or second audio output modules 152a or 152b, switch to a touch recognition mode of the display unit 151, and the like. The rear input unit may be configured to permit touch input, a push input, or combinations thereof.

The rear input unit may be located to overlap the display unit 151 of the front side in a thickness direction of the terminal body. As one example, the rear input unit may be located on an upper end portion of the rear side of the terminal body such that a user can easily manipulate it using a forefinger when the user grabs the terminal body with one hand. Alternatively, the rear input unit can be positioned at most any location of the rear side of the terminal body.

Embodiments that include the rear input unit may implement some or all of the functionality of the first manipulation unit 123a in the rear input unit. As such, in situations where the first manipulation unit 123a is omitted from the front side, the display unit 151 can have a larger screen.

As a further alternative, the mobile terminal 100 may include a finger scan sensor which scans a user's fingerprint. The controller 180 can then use fingerprint information sensed by the finger scan sensor as part of an authentication procedure. The finger scan sensor may also be installed in the display unit 151 or implemented in the user input unit 123.

The microphone 122 is shown located at an end of the mobile terminal 100, but other locations are possible. If desired, multiple microphones may be implemented, with such an arrangement permitting the receiving of stereo sounds.

The interface unit 160 may serve as a path allowing the mobile terminal 100 to interface with external devices. For example, the interface unit 160 may include one or more of a connection terminal for connecting to another device (for example, an earphone, an external speaker, or the like), a port for near field communication (for example, an Infrared Data Association (IrDA) port, a Bluetooth port, a wireless LAN port, and the like), or a power supply terminal for supplying power to the mobile terminal 100. The interface unit 160 may be implemented in the form of a socket for accommodating an external card, such as Subscriber Identification Module (SIM), User Identity Module (UIM), or a memory card for information storage.

The second camera 121b is shown located at the rear side of the terminal body and includes an image capturing direction that is substantially opposite to the image capturing direction of the first camera unit 121a. If desired, second camera 121a may alternatively be located at other locations, or made to be moveable, in order to have a different image capturing direction from that which is shown.

The second camera 121b can include a plurality of lenses arranged along at least one line. The plurality of lenses may also be arranged in a matrix configuration. The cameras may be referred to as an "array camera." When the second camera 121b is implemented as an array camera, images may be captured in various manners using the plurality of lenses and images with better qualities.

A flash 124 is shown located adjacent to the second camera 121b. When an image of a subject is captured with the camera 121b, the flash 124 may illuminate the subject.

The second audio output module 152b can be located on the terminal body. The second audio output module 152b may implement stereophonic sound functions in conjunction with the first audio output module 152a, and may be also used for implementing a speaker phone mode for call communication.

At least one antenna for wireless communication may be located on the terminal body. The antenna may be installed in the terminal body or formed by the case. For example, an antenna which configures a part of the broadcast receiving module 111 (see FIG. 1A) may be retractable into the terminal body. Alternatively, an antenna may be formed using a film attached to an inner surface of the rear cover 103, or a case that includes a conductive material.

A power supply unit 190 for supplying power to the mobile terminal 100 may include a battery 191, which is mounted in the terminal body or detachably coupled to an outside of the terminal body.

The battery 191 may receive power via a power source cable connected to the interface unit 160. Also, the battery 191 can be recharged in a wireless manner using a wireless charger. Wireless charging may be implemented by magnetic induction or electromagnetic resonance.

The rear cover 103 is shown coupled to the rear case 102 for shielding the battery 191, to prevent separation of the battery 191, and to protect the battery 191 from an external impact or from foreign material. When the battery 191 is detachable from the terminal body, the rear case 103 may be detachably coupled to the rear case 102.

An accessory for protecting an appearance or assisting or extending the functions of the mobile terminal 100 can also be provided on the mobile terminal 100. As one example of an accessory, a cover or pouch for covering or accommodating at least one surface of the mobile terminal 100 may be provided. The cover or pouch may cooperate with the display unit 151 to extend the function of the mobile terminal 100. Another example of the accessory is a touch pen for assisting or extending a touch input to a touch screen

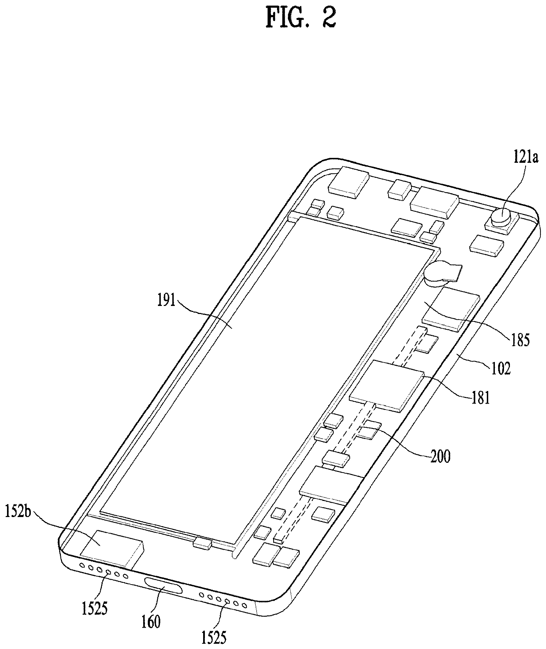

FIG. 2 is a view illustrating the rear case 102 of the mobile terminal 100 and parts mounted on the rear case 102 according to the present disclosure. The body of the mobile terminal 100 according to the present disclosure includes an inner space in which various parts such as a main board 185 and the battery 191 are mounted. Parts which emit heat during operation are referred to as heat emission parts 181. Considering that a main chip (application processor (AP)) 181 emits most heat among the heat emission parts 181, it is necessary to prevent a continuous increase in temperature by distributing heat generated from the main chip 181.

If heat is continuously generated from a specific portion of the mobile terminal 100, parts may be damaged. Since a user uses the mobile terminal 100, grabbing it with his or her hand, direct transfer of heat to the hand may bother the user. Particularly, when the user views a video or plays a game on the mobile terminal 100 as a multimedia device for long, with the main chip 181 performing intensive computations, much heat is generated, which makes a heat radiation function more important.

The extension of functions of the mobile terminal 100 is a driving force behind the need for a large-capacity requirement for the battery 191. On the other hand, as the terminal body becomes smaller in size, the main board 185 is disposed around the battery 191 so as to avoid overlap with the battery 191. Accordingly, a heat emission part such as the main chip 181 is located beside the battery 191.

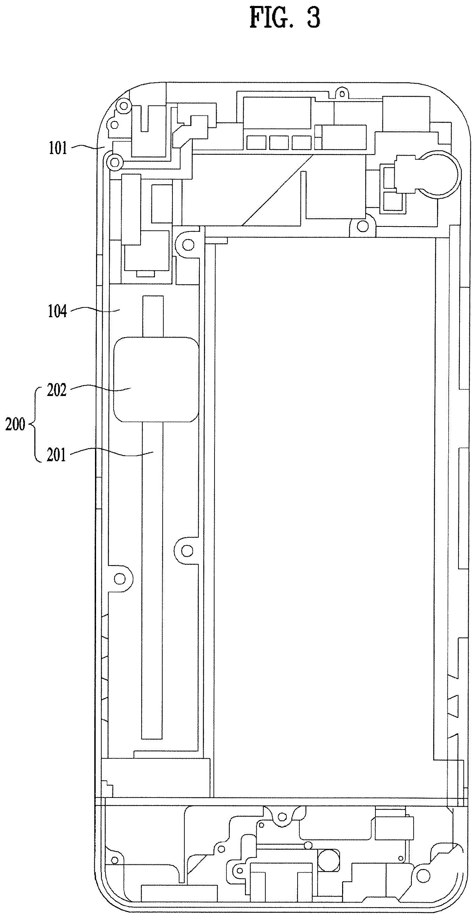

According to the present disclosure, a heat pipe 200 is adopted to distribute heat generated from the heat emission part 181. FIG. 3 is a view illustrating a metal frame 104 and the heat pipe 200 according to the present disclosure, in which the metal frame 104 is disposed behind the display unit 151 to support the display unit 151 and provide robustness to the mobile terminal 100. The metal frame 104 is formed of a metallic material such as aluminum or magnesium to achieve robustness.

The heat pipe 200 is disposed in contact with the metal frame 104, to thereby discharge heat by means of the metal frame. If a display unit which emits less heat, such as an organic light emitting diode (OLED) display is used, heat may radiate through the metal frame 104 .

If the battery 191 is heated, the battery 191 is vulnerable to explosion. Therefore, the heat pipe 200 is preferably positioned above or beside the battery 191.

The heat pipe 200 includes a heat absorption unit 202 which absorbs heat from the heat emission part 181 in contact therewith, and a heat transfer unit 201 which is extended from the heat absorption unit 202 and diffuses the absorbed heat to other areas.

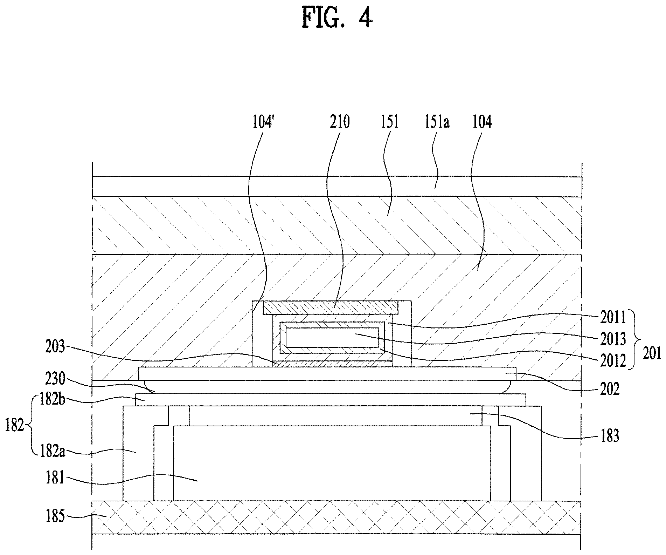

To absorb as much heat as possible from the heat emission part 181, the heat absorption unit 202 has an increased area matching the size of the heat emission part 181, and the heat pipe 200 is extended long along the length direction of the mobile terminal 100. FIG. 4 is a sectional view illustrating an example of the metal frame 104, the heat pipe 200, and the main board 185 according to the present disclosure.

The heat pipe 200 of the present disclosure is implemented as a metal member having high heat conductivity such as copper, and the heat absorption unit 202 is formed in the shape of a plate to cover the entirety of the heat emission part 181. The heat transfer unit 201 defines passages 2012 and 2013 therethrough, and the passages 2012 and 2013 are filled with a working fluid. When the temperature of the working fluid rises to or above a boiling point due to the heat absorbed by the heat absorption unit 202, the working fluid changes its state from liquid to gas and radiates heat while moving along the heat transfer unit 201. When the temperature of the working fluid drops to or below the boiling point, the working fluid changes its state from gas to liquid.

The heat transfer unit 201 is formed in the shape of a layered tube, including a pipe member 2011 at the outermost layer and passages inside the pipe member 2011. To separate a flow of the liquid-state working fluid from a flow of the gas-state working fluid, the heat transfer unit 201 may include a first passage 2012 and a second passage 2013 separately. Although the first passage 2012 and the second passage 2013 may be physically isolated and thus shielded from each other, the size of the heat pipe 200 mounted in a small-size product such as the mobile terminal 100 is very small, and thus the passages are configured in a fine structure.

As the first passage 2012 is positioned inside the pipe member 2011 and the second passage 2013 is formed along an inner sidewall of the pipe member 2011, surrounding the first passage 2012, the heat transfer unit 201 includes a plurality of layers in cross-section, as illustrated in FIG. 4. The liquid-state working fluid passes through the first passage 2012, whereas the gas-state working fluid passes through the second passage 2013. Since the section of the second passage 2013 is smaller than that of the first passage 2012, the fluid may move along a wall surface of the narrow second passage 2013 in view of the surface tension of the liquid (capillary phenomenon). The second passage 2013 may be formed in a structure having a small section, such as a mesh structure or a capillary tube.

Because heat is transferred faster through a fluid than through a conductor, heat is transferred fast through the heat transfer unit 201, which is effective in heat diffusion (a heat transfer rate of 5000 to 8000W/mK) in the heat transfer unit). However, the heat pipe 200 is smaller in size than the heat emission part 181, and thus the heat absorption unit 202 having a large area is used to transfer heat generated from the heat emission part 181 to the fluid in the heat transfer unit 201.

The heat absorption unit 202 and the heat transfer unit 201 according to the present disclosure are integrally engaged with each other by soldering or the like such that there is no gap therebetween. Conventionally, a graphite sheet having high heat conductivity or the like is used instead of the heat absorption unit 202 due to damage to the passages (particularly, the second passage 2013 in a fine structure) during high-temperature soldering.

However, a gap is produced between the graphite sheet and the heat pipe 200, resulting in low heat transfer efficiency, compared to the present disclosure in which the heat absorption unit 202 and the heat transfer unit 201 are integrally formed. According to the present disclosure, to increase heat transfer efficiency without damage to the passages, low-temperature soldering is used to provide the heat pipe 200 in which the heat absorption unit 202 having a large area is integrally formed with the heat transfer unit 201 including the passages 2012 and 2013.

Soldering, which is a technique of engaging two members with each other by means of solder paste 203 of a liquid-state or paste-state (semi-liquid-state) metallic material, offers the benefits of strong bonding force and high heat conductivity attributed to no gap between the two members. The heat absorption unit 202 and the heat transfer unit 201 may be engaged with each other without damage to the passages 2012 and 2013 of the heat transfer unit 201 by low-temperature soldering which can be performed even at low temperature, using the solder paste 203 of an alloy of tin and a metal melting at low temperature.

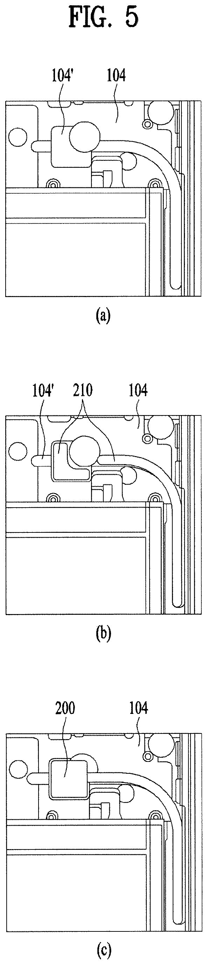

FIG. 5 is a view illustrating sequential engagement of the heat pipe 200 with the metal frame 104 according to the present disclosure. A recess 104' matching the heat pipe 200 is formed on the metal frame 104, thereby preventing an increase in the thickness of the metal frame 104 which might otherwise be increased by the heat pipe 200 (FIG. 5(a)). A heat conductive tape 210 is attached onto the recess 104' (FIG. 5(b)), and the heat pipe 200 is attached in the recess 104' by the adhesive force of the heat conductive tape 210. As illustrated in FIG. 4, the heat pipe 200 is embedded into the metal frame 104 by forming the recess 104' on the metal frame 104, thereby preventing a thickness increase caused by the heat pipe 200.

Referring to FIG. 4, the main chip 181 as a representative example of the heat emission parts 181 is shown as mounted on the main board 185. The main chip 181 may further include a shield can 182 which is mounted on the main board 185 and electrically shielded to prevent the main chip 181 from being broken by a physical impact and minimize the effects of other neighboring parts.

The shield can 182 is fixed on the main board 185, covering the side and top surfaces of the main chip 181. The shield can 182 includes a sidewall portion 182a fixed on the main board 185, surrounding the side surfaces of the main chip 181, and a shielding portion 182b mounted on an end portion of the sidewall potion 182a, covering the top surface of the main chip 181. The shielding portion 182b and the sidewall portion 182a may be integrally formed, or as illustrated in FIG. 4, with the sidewall portion 182a fixed on the main board 185, the shielding portion 182b is engaged with the end portion of the sidewall portion 182a. The sidewall portion 182a and the shielding portion 182b may be formed of different materials: for example, the former is formed of SUS and the latter is formed of copper.

To allow active transfer of heat generated from the main chip 181 to the heat absorption unit 202 of the heat pipe 200, heat transfer members 230 and 183 in a gel or paste state or a phase change material (PCM) may be interposed between the main chip 181 and the shielding portion 182b and between the shielding portion 182b and the heat absorption unit 202. The gel or paste can change its shape without flowing down, and thus does not transfer a physical impact directly, whereas the PCM transitions its phase at high temperature and thus is filled between members without any gap, thereby preventing the decrease of heat conductivity.

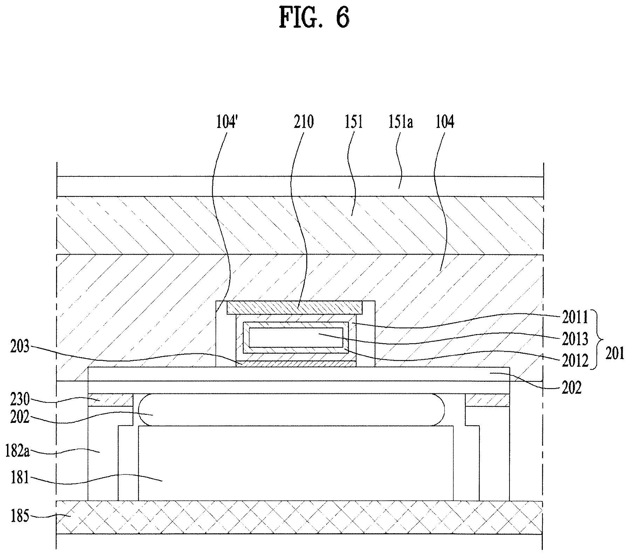

FIG. 6 depicts another embodiment of the present disclosure. As illustrated in FIG. 6, the heat absorption unit 202 may be engaged directly with the end portion of the sidewall portion 182a of the shield can 182, without the shielding portion 182b. In this case, the shielding portion 182b and one layer of the heat transfer members 230 and 183 are removed, compared to the embodiment of FIG. 4. Accordingly, the total thickness is reduced and a heat transfer path is shortened, thereby facilitating heat transfer to the heat pipe 200.

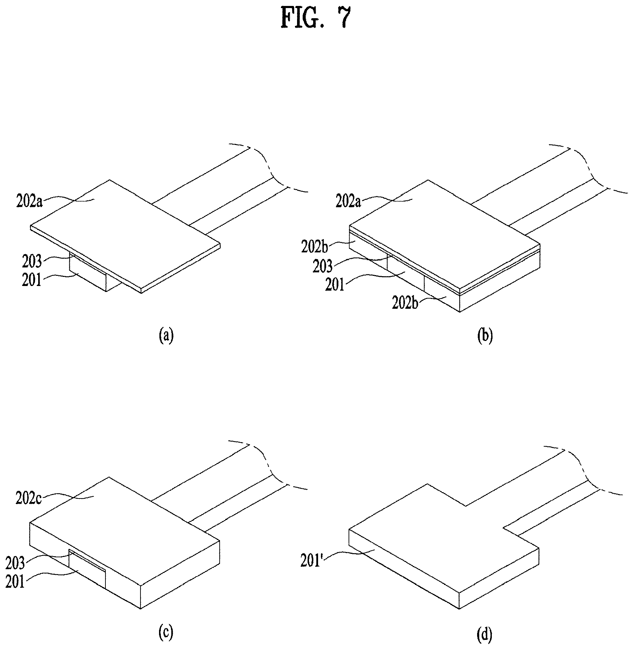

FIG. 7 is a view illustrating various embodiments of the heat pipe 200 according to the present disclosure. In FIG. 7, the heat emission part 181 is disposed over the illustrated component. As illustrated in FIG. 7(a), the heat transfer unit 201 may be engaged on a heat absorption plate 202a by low-temperature soldering. As illustrated in FIG. 7(b), heat absorption blocks 202b may be added on the left and right sides of the heat transfer unit 201.

In the embodiment of FIG. 7(c), a recess is formed on a heat absorption plate 202a thicker than the heat absorption plate 202a illustrated in FIG. 7(a), the heat transfer unit 201 is fit in the recess, and low-temperature soldering is performed between the heat transfer unit 201 and the recess of the heat absorption plate 202a.

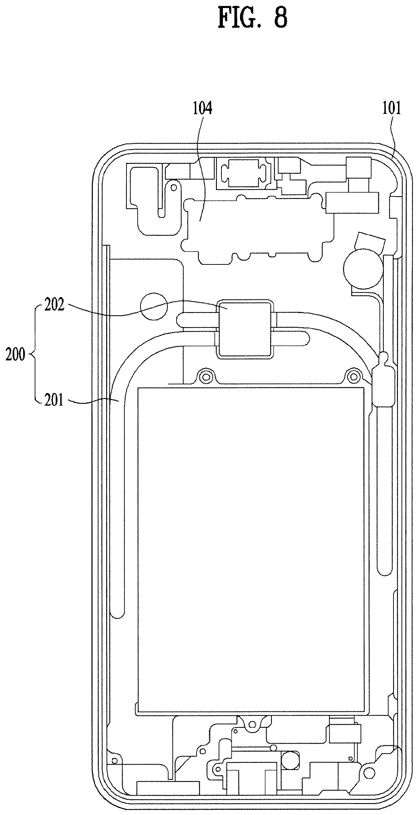

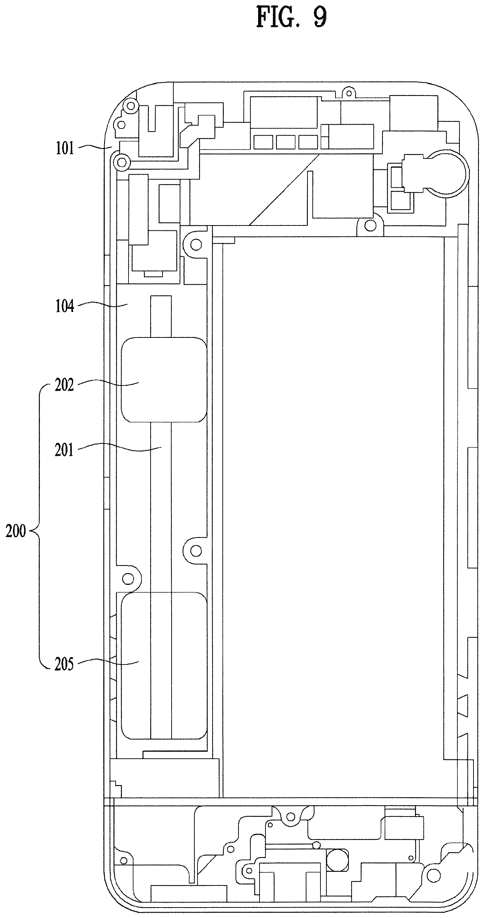

FIGS. 8 and 9 illustrate other embodiments of the heat pipe 200 according to the present disclosure. As illustrated in FIG. 8, a plurality of heat transfer units may be extended in different directions. The use of the plurality of heat transfer units 201 may lead to more effective distribution of heat generated from the heat emission part 181.

Further, as illustrated in FIG. 9, the heat pipe 200 may further include a heat diffusion unit 203 to maximize heat radiation at the other end of the heat transfer unit 201 to which heat absorbed by the heat absorption unit 202 located at one end of the heat transfer unit 201 is transferred. Like the heat absorption unit 202, the heat diffusion unit 203 may be engaged with the heat transfer unit 201 by low-temperature soldering.

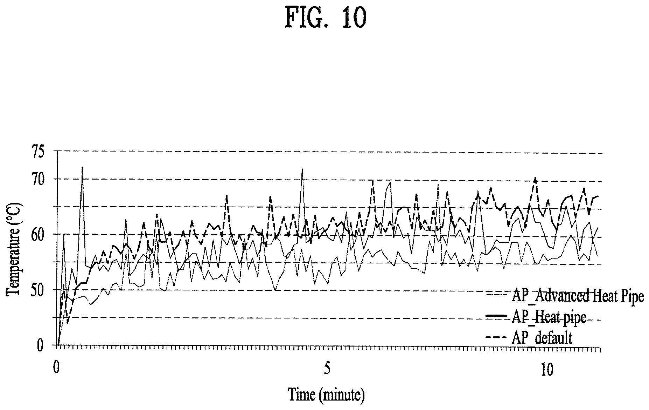

FIG. 10 is a graph illustrating temperatures of the heat emission part 181 in the cases of the absence of the heat pipe 200, use of the conventional heat pipe 200, and use of the heat pipe 200 of the present disclosure. Without the heat pipe 200, temperature is highest. Compared to the case of the conventional heat pipe 200 with only the heat transfer unit 201, the heat pipe 200 with the integrated heat absorption unit 202 according to the present disclosure exhibits lower temperature.

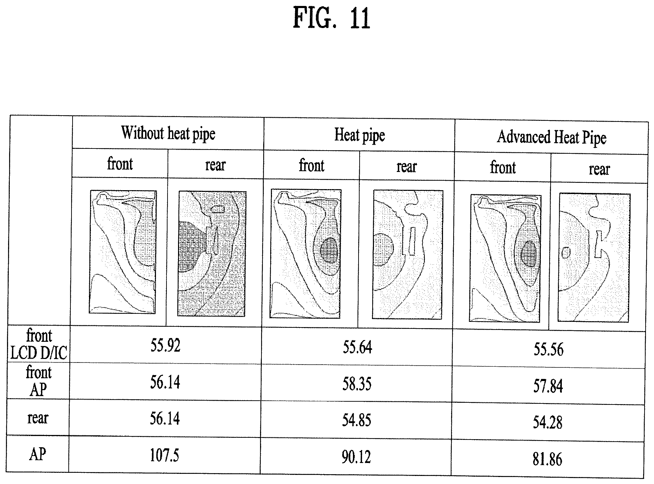

FIG. 11 is a table illustrating temperature distributions at different points in the cases of the absence of the heat pipe 200, use of the conventional heat pipe 200, and use of the heat pipe 200 of the present disclosure. In FIG. 11, darker shaded parts have higher temperature, and the use of the advanced heat pipe 200 of the present disclosure reduces overall temperature, compared to the case of the absence of the heat pipe 200 and the use of the conventional heat pipe 200.

Referring to the table listing specific numeral values, when the advanced heat pipe 200 of the present disclosure is also provided in a front display unit, temperature is low, with a temperature difference from the temperature of the rear surface by about 2°C. Thus, the main chip (AP) 181 suffers from a temperature difference of about 25°C. The temperature difference is 8°C or more relative to the conventional heat pipe 200.

As described above, the mobile terminal 100 of the present disclosure increases the area of the heat absorption unit 202 of the heat pipe 200, which contacts the heat emission part 181, thereby improving heat radiation performance.

Compared to the conventional structure, heat of the heat emission part 181 is efficiently distributed. Therefore, heat concentrated on the heat emission part 181 may be effectively reduced, and heat-caused damage to a key part such as the main chip 18 may be prevented.

Since the heat absorption unit 202 and the heat transfer unit 201 are coupled to each other by low-temperature soldering, damage to the passages of the heat pipe 200 may be prevented during the soldering, thereby reducing a failure rate.

As the present features may be embodied in several forms without departing from the characteristics thereof, it should also be understood that the above-described embodiments are not limited by any of the details of the foregoing description, unless otherwise specified, but rather should be considered broadly within its scope as defined in the appended claims, and therefore all changes and modifications that fall within the metes and bounds of the claims, or equivalents of such metes and bounds, are therefore intended to be embraced by the appended claims.

## Claims

1. A mobile terminal comprising:
a body including an inner space;
a main board mounted in the inner space, and configured to mount a heat emission part thereon; and
a heat pipe including a heat absorption unit contacting the heat emission part, and a heat transfer unit extended from the heat absorption unit,
wherein the heat absorption unit comprises a plate-shaped metal member having an area matching an area of the heat emission part,
wherein the heat transfer unit comprises:
a pipe member formed of a material with high heat conductivity;
a first passage formed inside the pipe member;
a second passage formed on an inner sidewall of the pipe member; and
a working fluid passing through the first passage in a gas state and passing through the second passage in a liquid state, and
wherein the heat absorption unit and the heat transfer unit are integrally formed.

2. The mobile terminal according to claim 1, further comprising:
a display unit disposed on a front surface of the body; and
a metal frame mounted in the inner space and supporting a rear surface of the display unit,
wherein the heat pipe contacts the metal frame.

3. The mobile terminal according to claim 2, wherein the metal plate further comprises a recess corresponding to a shape of the heat pipe.

4. The mobile terminal according to claim 2, further comprising a heat conductive tape interposed between the metal plate and the heat pipe.

5. The mobile terminal according to claim 1, further comprising a soldering portion disposed between the heat absorption unit and the heat transfer unit, and configured to engage the heat absorption unit with the heat transfer unit by low-temperature soldering.

6. The mobile terminal according to claim 1, wherein the heat absorption unit comprises:
a heat absorption plate including one surface contacting the heat emission part and the other surface engaged with the heat transfer unit by low-temperature soldering; and
a heat absorption block disposed around the heat transfer unit on the other surface of the heat absorption plate, and engaged with the heat absorption plate by low-temperature soldering.

7. The mobile terminal according to claim 1, wherein the heat absorption unit comprises a heat absorption plate including a recess matching the heat transfer unit formed thereon, and
wherein one end of the heat transfer unit is inserted into the recess and engaged with the heat absorption unit.

8. The mobile terminal according to claim 1, wherein the heat absorption unit is formed to be an extension of the pipe member from one end of the heat transfer unit.

9. The mobile terminal according to claim 1, further comprising a heat diffusion unit disposed at the other end of the heat transfer unit and including an expanded surface.

10. The mobile terminal according to claim 1, further comprising a battery mounted in the inner surface,
wherein the heat transfer unit is disposed at a side of the battery.

11. The mobile terminal according to claim 1, wherein the heat pipe comprises a plurality of heat transfer units extended from the heat absorption unit in different directions.

12. The mobile terminal according to claim 1, comprising:
a shield can covering the heat emission part and disposed between the heat emission part and the heat absorption unit;
a first heat transfer member interposed between the shield can and the heat emission part; and
a second heat transfer member interposed between the shield can and the heat absorption unit.

13. The mobile terminal according to claim 12, wherein the shield can comprises:
a sidewall portion fixed on the main board; and
a shielding portion mounted on an end portion of the sidewall portion.

14. The mobile terminal according to claim 1, further comprising:
a sidewall portion disposed around the heat emission part, fixed on the main board, and including an end portion engaged with the heat absorption unit; and
a third heat transfer member interposed between the heat absorption unit and the heat emission part.

15. The mobile terminal according to claim 1, comprising an organic light emitting diode (OLED) display mounted on a front surface of the body.
